# EUROPEAN PATENT APPLICATION

(11) **EP 4 089 917 A1**
(43) Date of publication of application: **16.11.2022**
(21) Application number: 20896027.8
(22) Date of filing: 06.05.2020
(51) Int. Cl.: H03H 3/007, H01L 23/31, H03H 9/02

(54) **CHIP PACKAGING MODULE AND PACKAGING METHOD THEREOF, AND ELECTRONIC DEVICE WITH CHIP PACKAGING MODULE**

(30) Priority: 04.12.2019 CN 201911227573
(71) Applicant: Tianjin University, Tianjin 300072 (CN); Rofs Microsystem (Tianjin) Co., Ltd, Tianjin 300462 (CN)
(72) Inventor: PANG, Wei, Tianjin 300072 (CN); WANG, Yunfeng, Tianjin 300462 (CN); YANG, Qingrui, Tianjin 300072 (CN); ZHANG, Menglun, Tianjin 300072 (CN)
(74) Representative: Meyer-Dulheuer MD Legal Patentanwälte PartG mbB
(86) International application number: PCT/CN2020/088704
(87) International publication number: WO 2021/109443

(57) **Abstract**

Disclosed are a chip packaging module and a packaging method thereof, and an electronic device with the chip packaging module. The chip packaging module includes: a chip (15); a package substrate (10), which faces the chip (15), a cavity being formed therebetween; a first packaging layer (17) for packaging the chip (15) on the package substrate (10); and a second packaging layer (19), which covers an outer side of the first packaging layer (17), wherein the first packaging layer (17) includes an extension part extending outwards in the transverse direction of the package substrate (10), a lower side of the extension part covers an upper side of the package substrate (10), and an end part of the second packaging layer (19) is in surface contact with an upper side of the extension part.

## Description

### TECHNICAL FIELD

The disclosure relates to the field of semiconductors, and in particular, to a chip packaging structure, a chip packaging method and an electronic device with a chip packaging module.

### BACKGROUND

As basic elements of an electronic apparatus, electronic devices have been widely applied, and their applications cover mobile phones, automobiles, home appliances and the like. In addition, technologies such as artificial intelligence, Internet of Things and 5G communication that will change the world in the future still need and rely on the electronic devices.

As an important member of the piezoelectric devices, a Film Bulk Acoustic Resonator (FBAR, also referred to as a bulk acoustic wave resonator (BAW)) is very important in the field of communication, and especially, an FBAR filter has gained a growing market share in the field of radio frequency filters. The traditional surface acoustic wave (SAW) filters and ceramic filters are gradually replaced by the FBAR filters due to their small size, high resonant frequency, high quality factor, large power capacity, good roll-off effect, and other excellent characteristics. Such the FBAR filters are used widely in the field of wireless communication radio frequency, and can be also applicable to the sensing filed such as biology, physics, and medicine due to their high sensitivity.

In general, there are specific packaging requirements for the film bulk acoustic resonators in different application environments. The wafer-level packaging is commonly used by far, which not only increases a size of a device, but also has a large number of packaging steps, thereby increasing the packaging cost. In recent years, with rapid development of wireless mobile communication technologies, the wireless communication apparatus gradually develops to be portable, multi-functional, have high performance and low cost, which prompts electronic elements to develop towards miniaturization, high integration, high reliability, and high yield, so do radio frequency filters.

In recent years, the packaging technology with a simple process and low cost has developed rapidly while satisfying the packaging requirements. However, the airtightness and reliability of the packaging structure still need to be improved.

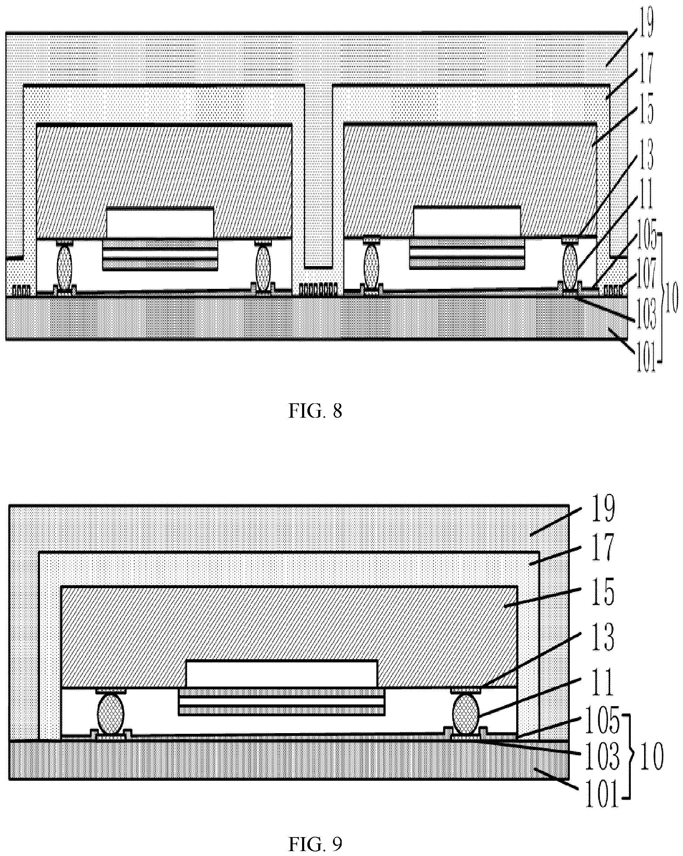

FIG. 9 is a schematic diagram of a chip packaging structure in the related art. In FIG. 9:
10 indicates a substrate, which may be made of ceramic, an organic material or the like, and includes three parts, i.e. a bottom substrate 101, a conductive layer 103, and an oil filter layer 105;
11 indicates a chip bonding structure, which may be MBM, a solder ball, a copper pillar and the like;
13 indicates a pad;
15 indicates an unpackaged filter chip, which may be an FBAR chip, SAW chip, or BAW chip;
17 indicates an adhesive layer between chips and a peripheral protective layer;
19 indicates an adhesive layer between chips and a peripheral protective layer.

In a structure shown in FIG. 9, the peripheral protective layer 17 and the substrate 10 are vacuum pressed such that poor tightness and adhesion are achieved at a contact portion thereof. In addition, moisture easily penetrates through the oil filter layer 105 to destroy a cavity structure required by the filter chip 15 and affect the performance of the apparatus.

### SUMMARY

To solve or alleviate at least one aspect of technical problems existing in the related art, the present disclosure is provided.

According to an aspect of embodiments of the present disclosure, there is provided a chip packaging module, which includes a chip, a packaging substrate arranged opposite to the chip, a cavity formed between the packaging substrate and the chip, a first packaging layer, and a second packaging layer. The first packaging layer is configured to package the chip on the packaging substrate. The second packaging layer is arranged to cover an outer side of the first packaging layer. The first packaging layer includes an extension portion extending laterally and outwardly along the packaging substrate, and a lower side of the extension portion covers an upper side of the packaging substrate. An end of the second packaging layer is arranged in surface contact with an upper side of the extension portion.

An embodiment of the disclosure further provides a chip packaging method. The chip packaging method includes: providing a packaging substrate; providing an unpackaged chip; bonding the chip to an upper side of the packaging substrate by flip-chip bonding; providing a first packaging layer in such a manner that the first packaging layer is configured to package the chip on the packaging substrate, the first packaging layer including an extension portion extending laterally and outwardly along the packaging substrate, and a lower side of the extension portion covering the upper side of the packaging substrate; and providing a second packaging layer that covers the first packaging layer, an end of the second packaging layer being arranged in surface contact with an upper side of the extension portion.

An embodiment of the disclosure also relates to an electronic device including the chip packaging module as described above or a chip packaging module manufactured according to the packaging method as described above.

### BRIEF DESCRIPTION OF DRAWINGS

The following description and drawings can facilitate to understand these and other features and advantages in various embodiments disclosed in the present disclosure. The same reference signs in the drawings always indicate the same components.
FIG. 1 is a schematic sectional view of a chip packaging module according to an exemplary embodiment of the present disclosure.
FIG. 2 is a schematic sectional view of a chip packaging module according to an exemplary embodiment of the present disclosure.
FIG. 2A is a partially enlarged schematic diagram of a contact portion between a first packaging layer and a substrate in FIG. 2.
FIG. 3 is a schematic sectional view of a chip packaging module according to an exemplary embodiment of the present disclosure.
FIG. 3A is a partially enlarged schematic diagram of a contact portion between a first packaging layer and a substrate in FIG. 3.
FIG. 4 is a schematic top view of a packaging structure of a chip packaging module according to an exemplary embodiment of the present disclosure.
FIG. 4A is an enlarged schematic diagram of a part A in FIG. 4.
FIG. 5 is a schematic top view of a packaging structure of a chip packaging module according to an exemplary embodiment of the present disclosure.
FIG. 5A is an enlarged schematic diagram of a part A in FIG. 5.
FIG. 5B is an enlarged schematic diagram of a part A in FIG. 5.
FIG. 6 is a schematic top view of a packaging structure of a chip packaging module according to an exemplary embodiment of the present disclosure.
FIG. 6A is an enlarged schematic diagram of a part A in FIG. 6.
FIGS. 7A to 7D are flowcharts illustrating a chip packaging method according to an embodiment of the present disclosure.
FIG. 8 is a schematic -sectional view of a chip packaging module according to an exemplary embodiment of the present disclosure, in which two chips are shown.

### DESCRIPTION OF EMBODIMENTS

The technical solutions of the present disclosure will be further described below in detail through embodiments and in conjunction with the drawings. The same or similar reference signs indicate the same or similar components throughout the description. The following description of embodiments of the present disclosure with reference to the drawings is intended to explain the general inventive concept of the present disclosure, and should not be construed as limitation to the present disclosure.

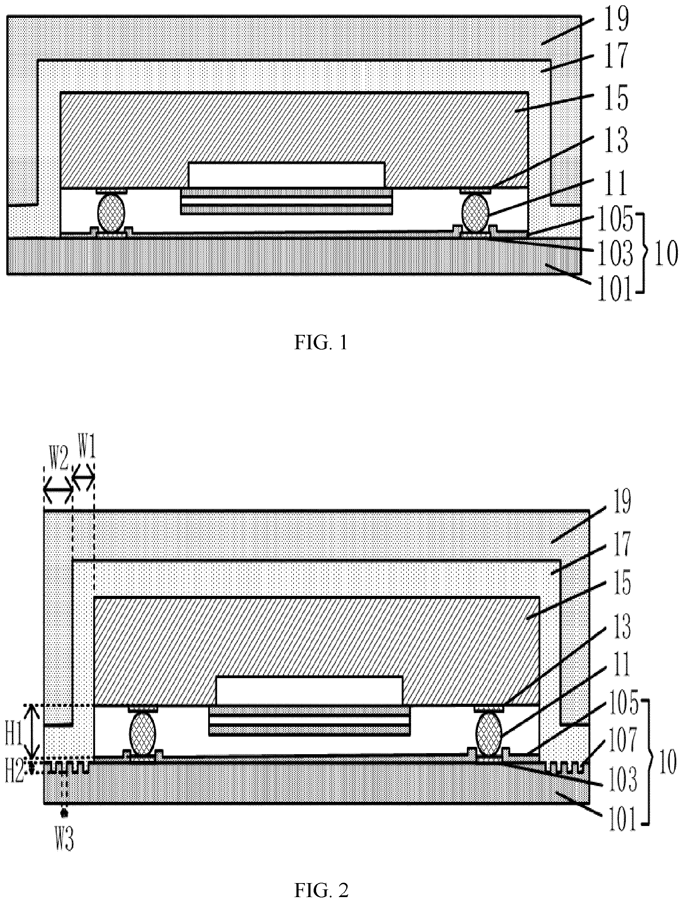

FIG. 1 is a schematic sectional view of a chip packaging module according to an exemplary embodiment of the present disclosure. In FIG. 1:
10 indicates a substrate, which may be made of ceramic, an organic material or the like. In an exemplary embodiment, the substrate 10 includes three parts, i.e. a bottom substrate 101, a conductive layer 103, and an oil filter layer 105.

11 indicates a chip bonding structure, which may be MBM, a solder ball, a copper pillar and the like.

13 indicates a pad.

15 indicates an unpackaged filter chip, which may be an FBAR chip, SAW chip, or BAW chip.

17 indicates a first packaging layer that includes a peripheral protective layer and an adhesive layer between chips.

19 indicates a second packaging layer that may also include a peripheral protective layer and an adhesive layer between chips.

As shown in FIG. 1, the first packaging layer 17 includes an extension portion extending laterally and outwardly along the packaging substrate. In FIG. 1, the extension portion is a lateral portion in contact with the substrate, and a lower side of the extension portion covers an upper side of the packaging substrate. As shown in FIG. 1, an end of the second packaging layer 19 is arranged in surface contact with an upper side of the extension portion.

In the present disclosure, "upper" and "lower" are determined in such a way that the substrate is at top and the chip is at bottom. In the present disclosure, an expression "lateral direction" is a direction parallel to a surface of the chip or substrate, and more specifically, the lateral direction can correspond to a left-right direction in the drawings.

In a structure of FIG. 1, since the extension portion increases a contact area between the first packaging layer and the substrate, the adhesion between the first packaging layer and the substrate is increased and sealing performance can be improved.

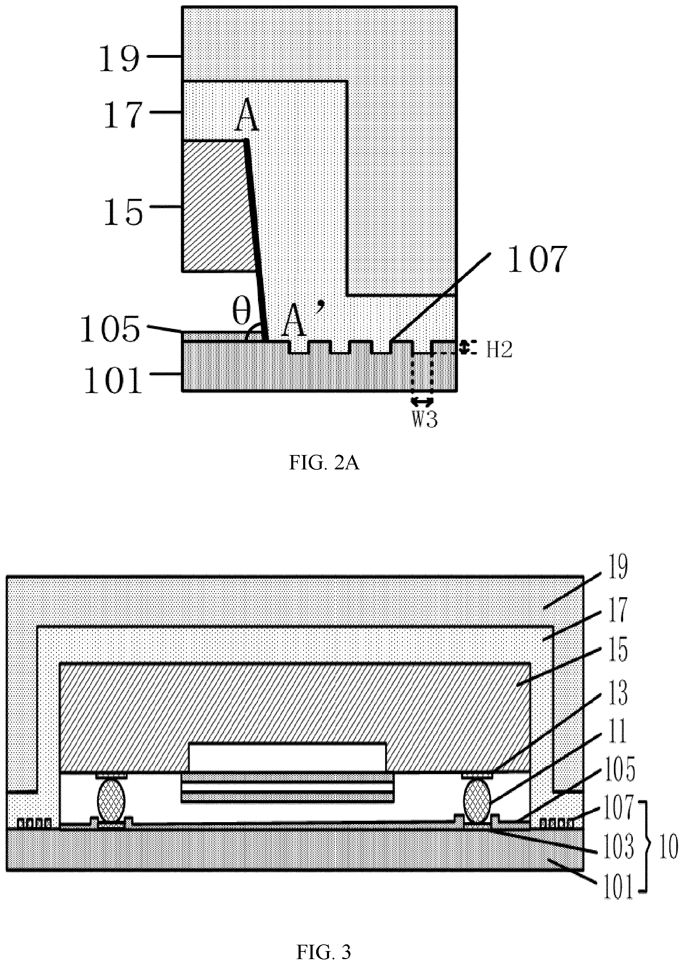

FIG. 2 is a schematic sectional view of a chip packaging module according to an exemplary embodiment of the present disclosure, and FIG. 2Ais a partially enlarged schematic diagram of a contact portion between a first packaging layer and a substrate in FIG. 2. As shown in FIG. 2, the substrate has recesses 107 at a position where the extension portion contacts, which facilitates to increase the adhesion of the first packaging layer to the substrate and improves the sealing effect.

As shown in FIG. 2, a height of a cavity is HI, which satisfy 10 µm≤H1≤150 µm. A depth of the recess is H2, which satisfy 0.05 µm≤H2≤10 µm. A width W3 of the recess satisfies W3≥H2.

In a further embodiment, as shown in FIGS. 2 and 2A, the first packaging layer 17 includes an upright portion covering a side surface of the semiconductor chip, and the upright portion is connected to the extension portion. An angle θ is formed between a surface of the upright portion facing toward the cavity and the upper side of the substrate, and satisfies 60<θ<90. As shown in FIG. 2A, in an embodiment, roughness of a side wall, that is, roughness of an upright surface AA' in FIG. 2A, is in a range of 10 Å to 10000 Å.

In a further embodiment of the present disclosure, as shown in FIG. 2, a first width W1 of the first packaging layer is less than a second width W2 of the second packaging layer, and the first width W1 depends on a thickness of the first packaging layer. The first width W1 may satisfy 0<W1≤50 µm, and the second width W2 may satisfy W2≥15 µm. An upper limit of the second width depends on a difference between a package dimension and a chip dimension. A specific value of the width W2 is determined based on the process capability and the difference between the package dimension and the chip dimension.

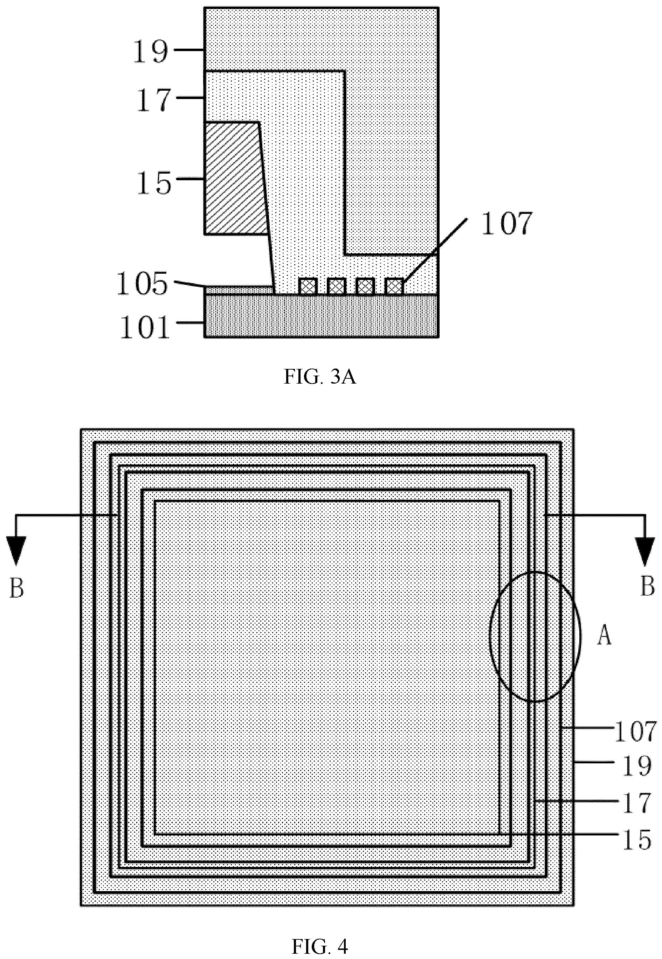

FIG. 3 is a schematic sectional view of a chip packaging module according to an exemplary embodiment of the present disclosure. A portion of the substrate contacting with the extension portion is formed with bulges. FIG. 3A is a partially enlarged schematic diagram of a contact portion between a first packaging layer and a substrate. A size of the bulge may be similar to that of the recess shown in FIG. 2. For example, the height of the cavity is HI, which satisfies 10 µm≤H1≤150 µm, and a height of the bulge is H2, which satisfies 0.05 µm≤H2≤ 10 µm. A width W3 of the bulge satisfies W3≥H2. In addition, when the bulge is provided, the height of the bump may be the same as a thickness of a metal layer on the surface layer of the substrate.

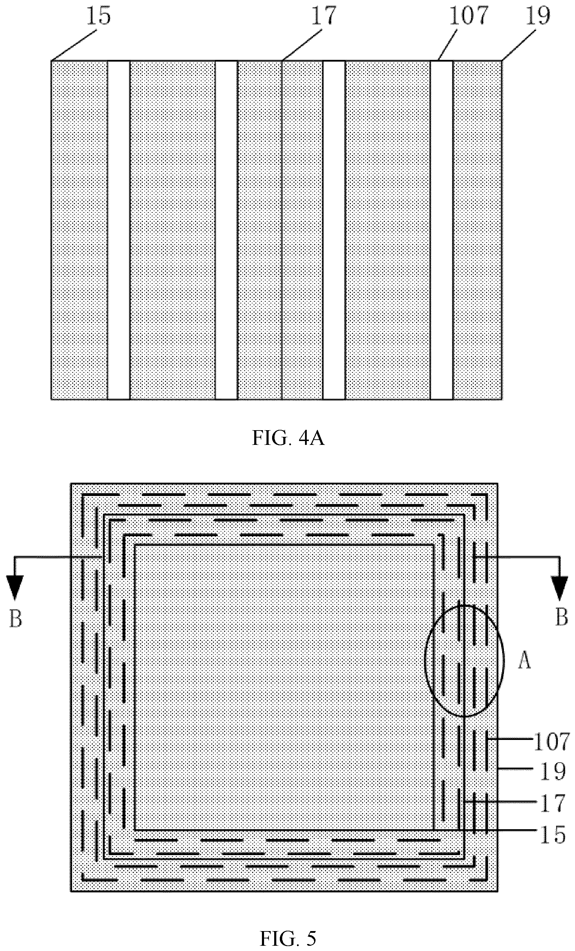

FIG. 4 is a schematic top view of a packaging structure of a chip packaging module according to an exemplary embodiment of the present disclosure, and FIG. 4A is an enlarged schematic diagram of a part A in FIG. 4. As shown in FIG. 4, the substrate is provided with an annular structure to improve the sealing property. As shown in FIG. 4A, a recess 107 is a strip recess, and there may be provided with a plurality of strip recesses.

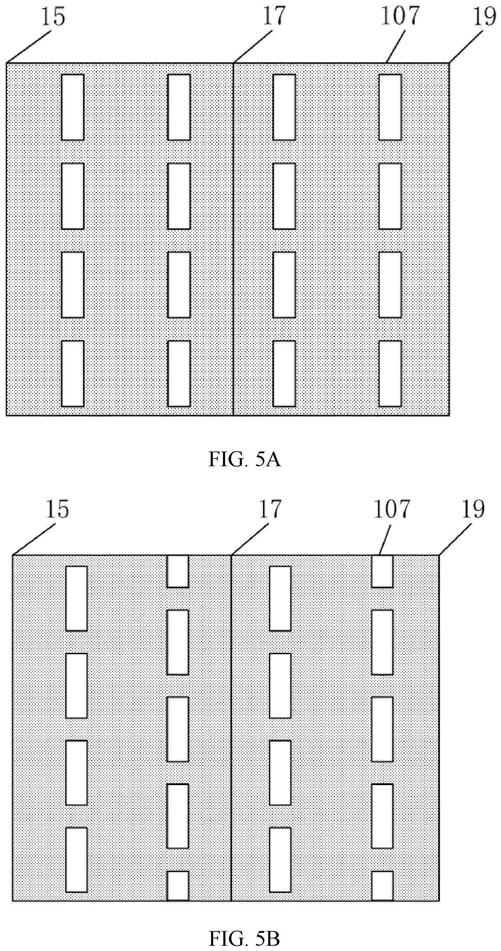

FIG. 5 is a schematic top view of a packaging structure of a chip packaging module according to an exemplary embodiment of the present disclosure, FIG. 5A is an enlarged schematic diagram of a part A in FIG. 5, and FIG. 5B is an enlarged schematic diagram of a part A in FIG. 5. As shown in FIG. 5, the substrate is provided with an annular structure to improve the sealing property, and the annular structure is formed by an intermittent structure. As shown in FIG. 5A, the recess 107 has a rectangular strip shape. In FIG. 5B, the rectangular recesses 107 distributed discretely are arranged in a staggered way. In this way, it is beneficial to enhance resistance of a gas passing therethrough in the lateral direction.

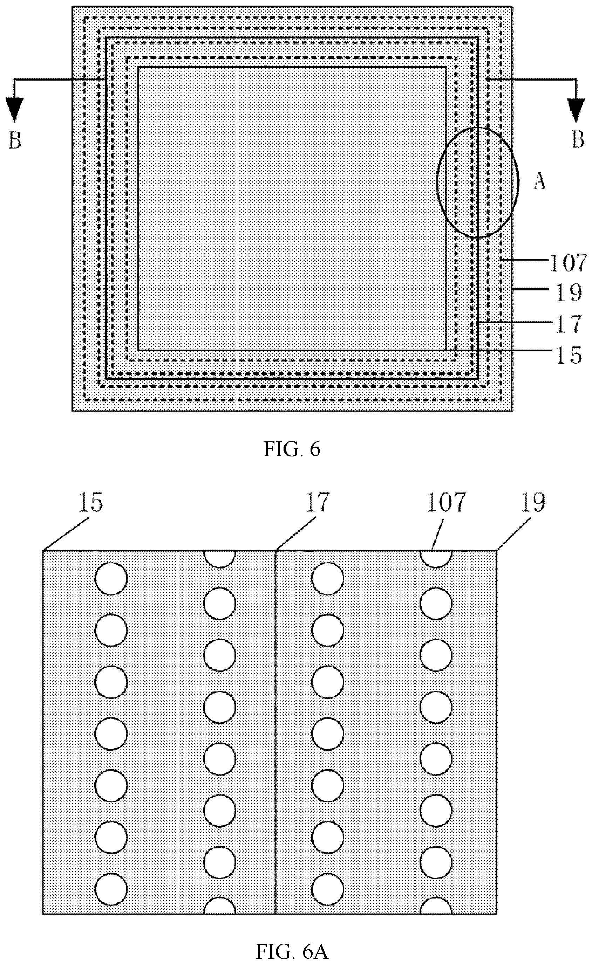

FIG. 6 is a schematic top view of a packaging structure of a chip packaging module according to an exemplary embodiment of the present disclosure, and FIG. 6A is an enlarged schematic diagram of a part A in FIG. 6. In FIGS. 6 and 6A, a recess 107 is a circular recess.

FIGS. 2 to 6A show a sealing reinforcement portion formed by bulges and/or recesses. However, the sealing reinforcement portion is not limited to this. For example, the sealing reinforcement portion may include a rough surface structure provided on the upper side of the packaging substrate 10.

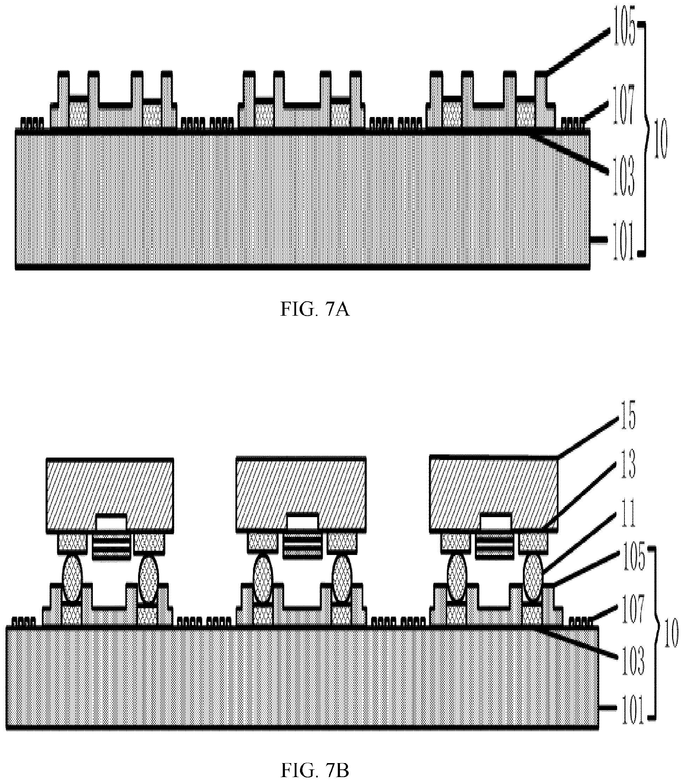

FIGS. 7A to 7D are flowcharts illustrating a chip packaging method according to an embodiment of the present disclosure. The chip packaging method is exemplarily described below with reference to FIGS. 7A to 7D.

As shown in FIG. 7A, an oil filter layer 105 of a substrate 10 is etched to expose a desired conductive portion 103, bulges 107, and a portion of the substrate 101 to be pressed and contacted.

As shown in FIG. 7B, a plurality of unpacked filter chips 15 are flip-chip bonded to the substrate 10.

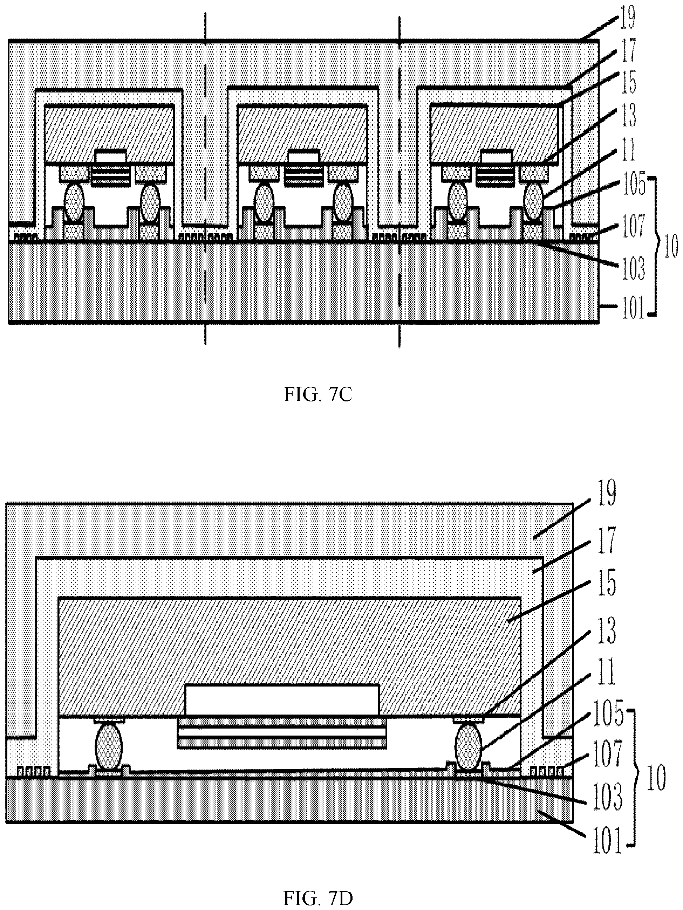

As shown in FIG. 7C, sealing is performed by vacuum pressing to form a first sealing layer 17 and a second sealing layer 19. Thereafter an air cavity is provided for each of the filter chips 15, and laser cutting is then performed along an upright dotted line.

It should be noted that, when a plurality of chips are bonded to the substrate by flip-chip bonding, the chips are spaced apart from each other in the lateral direction. A width of the extension portion between two adjacent chips is greater than or equal to 30 µm, and is twice or more times the first width. As can be understood, an expression "twice" is an approximate number, which, for example, may fall in a range of 1.5 times to 2.5 times.

As shown in FIG. 7D, a packaged chip is obtained after cutting.

It should be noted that the packaging method described above can be used to integrate a plurality of filter chips, or to integrate a plurality of active chips with filter chips.

FIG. 8 is a schematic sectional view of a chip packaging module according to an exemplary embodiment of the present disclosure, in which two chips are shown. In the present disclosure, the filter chips includes at least one of a bulk acoustic wave filter or a surface acoustic wave filter.

In view of the above, the present disclosure provides following technical solutions.
1. A chip packaging module includes:
   a chip;
   a packaging substrate arranged opposite to the chip;
   a cavity formed between the packaging substrate and the chip;
   a first packaging layer configured to package the chip on the packaging substrate; and
   a second packaging layer arranged to cover an outer side of the first packaging layer,
   wherein the first packaging layer includes an extension portion extending laterally and outwardly along the packaging substrate, a lower side of the extension portion covers an upper side of the packaging substrate, and an end of the second packaging layer is arranged in surface contact with an upper side of the extension portion.
2. The chip packaging module according to 1, wherein
   a part of the packaging substrate at least covered by the extension portion is provided with a sealing reinforcement portion.
3. The chip packaging module according to 2, wherein
   the sealing reinforcement portion includes a recess structure or a bulge structure provided on the upper side of the packaging substrate.
4. The chip packaging module according to 3, wherein
   the recess structure or bulge structure includes a strip-shaped annular array structure, a rectangular array structure, or a circular array structure that is formed by recesses or bulges.
5. The chip packaging module according to 3, wherein
   a height of the cavity is HI, which satisfies 10 µm≤H1≤150 µm;
   a depth of the recess structure or a height of the bulge structure is H2, which satisfies 0.05 µm ≤H2 ≤10 µm; and
   a width W3 of the recess structure or the bulge structure satisfies W3≥H2.
6. The chip packaging module according to 2, wherein
   the sealing reinforcement portion includes a rough surface structure provided on the upper side of the packaging substrate.
7. The chip packaging module according to any one of 1 to 6, wherein
   the sealing reinforcement portion is disposed in an annular arrangement.
8. The chip packaging module according to 7, wherein
   the sealing reinforcement portion includes an intermittent structure disposed in an annular arrangement.
9. The chip packaging module according to 1, wherein
   in a cross-sectional view extending through the chip and parallel to an upper surface of the chip, a first width W1 of the first packaging layer is less than a second width W2 of the second packaging layer.
10. The chip packaging module according to 9, wherein
   a range of the first width W1 satisfies 0<W1≤50 µm, and the second width W2 satisfies W2≥15 µm.
11. The chip packaging module according to any one of 1 to 10, wherein
   the first packaging layer includes an upright portion covering a side surface of the semiconductor chip, and the upright portion is connected with the extension portion; and
   an angle θ is formed between a surface of the upright portion facing toward the cavity and the upper side of the substrate, and satisfies 60<θ<90.
12. The chip packaging module according to any one of 1 to 10, wherein
   the chip includes at least a filter chip, and the filter chip includes at least one of a bulk acoustic wave filter or a surface acoustic wave filter.
13. The chip packaging module according to 12, wherein
   the chip is a chip assembly including a plurality of chips, which is arranged on a same layer and spaced apart from each other in a lateral direction;
   in the lateral direction, the plurality of chips is separated from each other by the first packaging layer; and
   the extension portion of the first packaging layer is arranged at an outer side of the chip assembly.
14. The chip packaging module according to 13, wherein
   the chip assembly includes a plurality of filter chips, or the chip assembly includes filter chips and active chips.
15. A chip packaging method includes:
   providing a packaging substrate;
   providing an unpackaged chip;
   bonding the chip to an upper side of the packaging substrate by flip-chip bonding;
   providing a first packaging layer in such a manner that the first packaging layer packages the chip on the packaging substrate, the first packaging layer including an extension portion extending laterally and outwardly along the packaging substrate, and a lower side of the extension portion covering the upper side of the packaging substrate; and
   providing a second packaging layer that covers the first packaging layer, an end of the second packaging layer being arranged in surface contact with an upper side of the extension portion.
16. The method according to 15, wherein
   the providing the packaging substrate further includes providing a sealing reinforcement portion at a predetermined position on the packaging substrate, the predetermined position is covered by the extension portion.
17. The method according to 15 or 16, wherein
   the bonding the chip to the upper side of the packaging substrate by flip-chip bonding includes bonding a plurality of chips to the upper side of the packaging substrate by flip-chip bonding, wherein the plurality of chips is spaced apart from each other in the lateral direction; and
   the first packaging layer has a first width W1, and in the providing the first packaging layer, a width of the extension portion between two adjacent ones of the plurality of chips is not less than 30 µm, and is twice or more times than the first width W1.
18. The method according to 17, wherein
   the bonding the chip to the upper side of the packaging substrate by flip-chip bonding includes bonding a plurality of filter chips to the upper side of the packaging substrate by flip-chip bonding or bonding filter chips and active chips to the upper side of the packaging substrate by flip-chip bonding.
19. The method according to 17 or 18 further includes:
   performing cutting between predetermined adjacent chips to form a plurality of independent chip packaging modules.
20. An electronic device includes the chip packaging module according to any one of 1 to 14 or a chip packaging module manufactured by the chip packaging method according to any one of 15 to 19.

Although the embodiments of the present disclosure have been shown and described, it should be understood for those skilled in the art that modifications may be made to these embodiments without departing from the principle and spirit of the present disclosure, and the scope thereof is defined by the appended claims and their equivalents.

## Claims

1. A chip packaging module, comprising:
a chip;
a packaging substrate arranged opposite to the chip;
a cavity formed between the packaging substrate and the chip;
a first packaging layer configured to package the chip on the packaging substrate; and
a second packaging layer arranged to cover an outer side of the first packaging layer,
wherein the first packaging layer comprises an extension portion extending laterally and outwardly along the packaging substrate, a lower side of the extension portion covers an upper side of the packaging substrate, and an end of the second packaging layer is arranged in surface contact with an upper side of the extension portion.

2. The chip packaging module according to claim 1, wherein a part of the packaging substrate at least covered by the extension portion is provided with a sealing reinforcement portion.

3. The chip packaging module according to claim 2, wherein the sealing reinforcement portion comprises a recess structure or a bulge structure provided on the upper side of the packaging substrate.

4. The chip packaging module according to claim 3, wherein the recess structure or bulge structure comprises a strip-shaped annular array structure, a rectangular array structure, or a circular array structure that is formed by recesses or bulges.

5. The chip packaging module according to claim 3, wherein a height of the cavity is HI, which satisfies 10 µm ≤ H1 ≤ 150 µm;
a depth of the recess structure or a height of the bulge structure is H2, which satisfies 0.05 µm ≤ H2 ≤ 10 µm; and
a width of the recess structure or the bulge structure is W3, which satisfies W3≥H2.

6. The chip packaging module according to claim 2, wherein the sealing reinforcement portion comprises a rough surface structure provided on the upper side of the packaging substrate.

7. The chip packaging module according to any one of claims 1 to 6, wherein the sealing reinforcement portion is disposed in an annular arrangement.

8. The chip packaging module according to claim 7, wherein the sealing reinforcement portion comprises an intermittent structure disposed in an annular arrangement.

9. The chip packaging module according to claim 1, wherein in a cross-sectional view extending through the chip and parallel to an upper surface of the chip, a first width W1 of the first packaging layer is less than a second width W2 of the second packaging layer.

10. The chip packaging module according to claim 9, wherein a range of the first width W1 satisfies 0<W1≤50 µm, and the second width W2 satisfies W2≥15 µm.

11. The chip packaging module according to any one of claims 1 to 10, wherein the first packaging layer comprises an upright portion covering a side surface of the semiconductor chip, and the upright portion is connected with the extension portion; and
an angle formed between a surface of the upright portion facing toward the cavity and the upper side of the substrate is θ, which satisfies 60<θ<90.

12. The chip packaging module according to any one of claims 1 to 10, wherein the chip comprises at least a filter chip, and the filter chip comprises at least one of a bulk acoustic wave filter or a surface acoustic wave filter.

13. The chip packaging module according to claim 12, wherein the chip is a chip assembly comprising a plurality of chips, which is arranged in a same layer and spaced apart from each other in a lateral direction;
in the lateral direction, the plurality of chips is separated from each other by the first packaging layer; and
the extension portion of the first packaging layer is arranged at an outer side of the chip assembly.

14. The chip packaging module according to claim 13, wherein the chip assembly comprises a plurality of filter chips, or the chip assembly comprises filter chips and active chips.

15. A chip packaging method, comprising:
providing a packaging substrate;
providing an unpackaged chip;
bonding the chip to an upper side of the packaging substrate by flip-chip bonding;
providing a first packaging layer in such a manner that the first packaging layer is configured to package the chip on the packaging substrate, the first packaging layer comprising an extension portion extending laterally and outwardly along the packaging substrate, and a lower side of the extension portion covering the upper side of the packaging substrate; and
providing a second packaging layer that covers the first packaging layer, an end of the second packaging layer being arranged in surface contact with an upper side of the extension portion.

16. The method according to claim 15, wherein the providing the packaging substrate further comprises providing a sealing reinforcement portion at a predetermined position on the packaging substrate, the predetermined position is covered by the extension portion.

17. The method according to claim 15 or 16, wherein the bonding the chip to the upper side of the packaging substrate by flip-chip bonding comprises bonding a plurality of chips to the upper side of the packaging substrate by flip-chip bonding, wherein the plurality of chips is spaced apart from each other in the lateral direction; and
the first packaging layer has a first width W1, and in the providing the first packaging layer, a width of the extension portion between two adjacent ones of the plurality of chips is not less than 30 µm, and is twice or more times than the first width W1.

18. The method according to claim 17, wherein the bonding the chip to the upper side of the packaging substrate by flip-chip bonding comprises bonding a plurality of filter chips to the upper side of the packaging substrate by flip-chip bonding or bonding filter chips and active chips to the upper side of the packaging substrate by flip-chip bonding.

19. The method according to claim 17 or 18, further comprising:
performing cutting between predetermined adjacent chips to form a plurality of independent chip packaging modules.

20. An electronic device, comprising the chip packaging module according to any one of claims 1 to 14 or a chip packaging module manufactured by the chip packaging method according to any one of claims 15 to 19.
